# FASCICULE DE BREVET EUROPEEN

(11) **EP 2 326 607 B1**
(45) Date de publication et mention de la délivrance du brevet: **21.12.2016**
(21) Numéro de dépôt: 09741365.2
(22) Date de dépôt: 03.09.2009
(51) Int. Cl.: C04B 35/573, C04B 41/87, C04B 35/80, C04B 41/00, C04B 41/50, C30B 11/00, C30B 29/06, C30B 35/00

(54) **MATERIAU A ARCHITECTURE MULTICOUCHE, DEDIE A UNE MISE EN CONTACT AVEC DU SILICIUM LIQUIDE**
VIELSCHICHTMATERIAL FÜR DIE VERWENDUNG ZUM KONTAKT MIT FLÜSSIGEM SILIZIUM
MULTILAYER MATERIAL, USED FOR CONTACTING LIQUID SILICON

(30) Priorité: 05.09.2008 FR 0855972
(43) Date de publication de la demande: 01.06.2011
(73) Titulaire: Commissariat à l'Énergie Atomique et aux Énergies Alternatives, 75015 Paris (FR)
(72) Inventeur: GARANDET, Jean-Paul, F-38000 Grenoble (FR); CAMEL, Denis, F-73000 Chambery (FR); DREVET, Béatrice, F-38000 Grenoble (FR); EUSTATHOPOULOS, Nicolas, F-38100 Grenoble (FR); ISRAEL, Rana, F-38000 Grenoble (FR)
(74) Mandataire: Nony
(86) Numéro de dépôt international: PCT/FR2009/051668
(87) Numéro de publication internationale: WO 2010/026344

(56) Documents cités:
- EP-A- 0 228 166
- EP-A- 0 409 983
- FR-A- 2 068 160
- FR-A- 2 207 883
- FR-A- 2 387 923
- US-A1- 2008 241 475

## Description

La présente invention vise à proposer de nouveaux matériaux utilisables dans les procédés de fusion et de solidification de silicium et notamment dédiés à des applications photovoltaïques. Elle vise en outre un procédé de préparation de ces matériaux.

Les cellules photovoltaïques sont pour l'essentiel fabriquées à partir de silicium mono- ou poly-cristallin, obtenu à partir de la solidification de silicium liquide dans des creusets. Ce sont les plaquettes découpées dans le lingot formé au sein du creuset qui servent de base à la fabrication des cellules.

La croissance du lingot est généralement réalisée dans des creusets en silice, revêtus d'une couche de nitrure de silicium pour éviter l'adhérence du lingot au creuset après solidification. Malheureusement, ce type de creuset en silice n'est pas réutilisable.

Ce problème est partiellement surmonté avec l'utilisation de creuset en graphite.

De tels creusets sont notamment utilisés pour la fusion du silicium dans les procédés de purification du silicium métallurgique. Quand le silicium liquide est mis en contact avec le graphite, une couche de carbure de silicium se forme par réaction à l'interface. La réaction se poursuit jusqu'à ce qu'une couche barrière étanche, s'intercale entre le matériau carboné et le silicium liquide. Entre temps, le silicium s'infiltre dans la matrice carbonée, jusqu'à une profondeur qui dépend principalement de la porosité de cette matrice. Par exemple, sur des matériaux de type graphite extrudé, des profondeurs centimétriques sont souvent atteintes, alors qu'elles sont de l'ordre du millimètre pour des graphites à grains fins. En revanche, dans le carbone vitreux, aucune infiltration notable n'est observée, seule la couche barrière se forme par réaction à l'interface

Une siliciuration du graphite en phase gazeuse est également possible. Par exemple, la société Toyotanso commercialise sous la marque PERMA KOTE^{®} un graphite revêtu de SiC par la technique CVD (3). Les épaisseurs de SiC peuvent être relativement importantes, de l'ordre de 100 µm, mais la couche n'est jamais parfaitement dense et peut poser des problèmes d'étanchéité. Ainsi, l'infiltration du silicium dans les porosités et le contact avec un graphite n'ayant pas réagi peuvent détruire la couche de carbure du fait du changement de volume associé à la réaction de siliciuration.

En fait, quelque soit la technique retenue pour former la couche SiC en surface du creuset en graphite, la protection assurée par la couche barrière en SiC n'est pas durable. Deux mécanismes contribuent à la consommation de cette couche. Pour les parties en contact avec le silicium fondu, le système a tendance à évoluer vers un état d'équilibre où le liquide se sature en carbone par dissolution de la couche de SiC. Pour les parties en contact avec une atmosphère oxydante, l'oxydation du SiC va également avoir pour effet une réduction de l'épaisseur de la couche.

En conséquence, ces creusets sont, par rapport aux creusets en silice, certes réutilisables mais leur durée de vie demeure encore limitée.

FR2068160A décrit une pièce en graphite avec une porosité de 30% et de particules de 1-100 microns. Cette pièce est mise en contact avec du silicium liquide sous vide à une température comprise entre 1500 et 1700°C. Après 15 minutes une épaisseur minimum de 10 mm est imprégnée. Après l'imprégnation la pièce est traitée à 1500-1600°C pendant 30 minutes pour transformer ou éliminer le silicium libre.

EP0228166A décrit un support à base de graphite, qui est infiltré par du silicium liquide. Le revêtement de SiC qui en résulte contient 2% en poids de Si et a une épaisseur de 1,05 mm.

FR2207883A décrit un support à base de graphite, qui est infiltré par du silicium liquide. Les particules de graphite ont un diamètre moyen d'environ 5 microns et une granulométrie de moins de 25 microns et le support formé a une porosité de 18-25%. La couche de SiC qui résulte de l'infiltration de Si dans le corps de graphite a une épaisseur de 0,381 mm. Au-dessus de cette couche de SiC une autre couche de SiC est formée, avec une épaisseur de 0,0127 mm et plus.

EP0409983A décrit aussi un support à base de graphite, qui est infiltré par du silicium liquide. Le support a une porosité de 32%. La couche de SiC qui résulte de l'infiltration de Si dans le corps de graphite a une épaisseur de 1,4 mm ou 2,4 mm. La couche de SiC contient très peu de Si solide.

La présente invention vise précisément à proposer une nouvelle structure composite carbure de silicium/graphite permettant d'augmenter significativement la durée de vie des matériaux destinés à être portés à des températures très élevées, à l'image notamment des creusets destinés à recevoir du silicium en fusion.

Ainsi, la présente invention vise également à proposer un nouveau type de creusets apte à être réutilisé.

La présente invention vise en particulier à proposer un nouveau type de creusets particulièrement avantageux en terme de non-adhérence à l'égard du silicium.

La présente invention vise en outre à proposer un procédé de préparation utile pour la préparation de telles pièces.

Plus précisément, la présente invention concerne, selon un de ses aspects, une pièce de matériau, notamment dédiée à une mise en contact avec du silicium liquide, possédant une architecture multicouche formée d'au moins une couche dite « de support » à base de carbone, d'une couche dite « de surface » en carbure de silicium, et d'une couche, dite « intermédiaire », intercalée entre lesdites couches de support et de surface caractérisée en ce que ladite couche intermédiaire est formée d'une matrice de carbure de silicium contenant au moins un nodule de carbone.

Avantageusement, les couches de surface et intermédiaire possèdent moins de 5 %, notamment moins de 1 % en volume de silicium solide, et en particulier sont totalement dénuées de silicium solide.

En ce qui concerne la couche intermédiaire, elle se caractérise par une homogénéité en terme de composition dans toute son épaisseur.

La matrice de carbure de silicium formant la couche intermédiaire comprend au moins 30 % en volume de nodule(s) de carbone, en particulier au moins 40 % en volume avantageusement répartis uniformément dans l'épaisseur de la couche intermédiaire.

Comme précisé ci-après, cette couche intermédiaire possède une fraction volumique en SiC au moins 1,8 fois plus élevée à la fraction volumique de la porosité graphite de la couche dite de support à base de carbone, représentative de la composition de la surface d'origine du matériau avant traitement selon l'invention.

Selon un mode de réalisation avantageux, la pièce de matériau conforme à l'invention possède une couche de surface en carbure de silicium possédant une épaisseur d'au moins 5 µm, notamment variant de 15 µm à 20 µm.

Avantageusement, la pièce de matériau conforme à l'invention possède une couche intermédiaire possédant une épaisseur d'au moins 300 µm, en particulier supérieure à 400 µm et notamment variant de 500 à 2000 µm.

Selon un mode préféré de l'invention, la pièce de matériau est un creuset ou un moule, destiné notamment à être mis en contact avec un matériau porté à une température très élevée tel que par exemple du silicium liquide.

Il peut également s'agir d'une partie d'un moule ou creuset qui par assemblage avec une ou plusieurs autres pièces, permet précisément de former ledit creuset ou moule.

Les creusets selon l'invention s'avèrent mieux adaptés que leurs homologues en graphite à plusieurs titres.

Tout d'abord, ils sont multi-usages.

De plus, pour les procédés de fusion, leur structure composite leur confère une résistance au silicium liquide et à l'oxydation, significativement améliorée dans la mesure où l'épaisseur de la couche intermédiaire est très supérieure aux dimensions usuelles.

Par ailleurs, la protection chimique du silicium vis-à-vis des impuretés contenues dans le graphite s'en trouve également améliorée.

Enfin, pour les procédés de solidification, la tenue de la couche anti-adhérente Si₃N₄ est meilleure sur substrat SiC que sur substrat graphite, car il est possible de réaliser le recuit du dépôt anti-adhérent en nitrure à plus haute température.

Avantageusement, les pièces de matériau selon l'invention sont ainsi compatibles avec une utilisation à température pouvant atteindre jusqu'à 1600 °C.

Selon un autre de ses aspects, la présente invention vise à proposer un procédé de préparation d'une pièce de matériau possédant une architecture multicouche composée d'au moins une couche dite « de support » à base de carbone, d'une couche dite « de surface » en carbure de silicium et d'une couche dite « intermédiaire » intercalée entre les deux précédentes couches et formée d'au moins une matrice de carbure de silicium contenant au moins un nodule de carbone, ledit procédé comprenant au moins les étapes consistant à :
(1) disposer d'une pièce de matériau comprenant au moins une couche externe carbonée de porosité volumique variant de 25 % à 40 %, de préférence de 30 % à 35 %, et s'étendant de préférence sur une épaisseur d'au moins 1000 µm,
(2) mettre en contact ladite pièce avec du silicium liquide,
(3) maintenir l'ensemble à une température variant de 1410 à 1500 °C et propice à l'infiltration dudit silicium liquide dans les pores de la couche carbonée et la formation d'une zone composite formée d'une matrice de graphite intégrant des nodules de SiC, et
(4) porter la pièce obtenue à l'issue de l'étape précédente à une température comprise entre 1500 °C et 1700° C, de préférence de 1500 °C à 1600 °C pour former lesdites couches de surface et intermédiaire attendues et notamment telles que définies ci-dessus et consommer pour l'essentiel le silicium résiduel de l'étape précédente.

Selon un mode préféré de l'invention, la température de l'étape (3) peut être avantageusement ajustée entre la température de fusion du silicium à savoir d'environ 1410 °C à environ 1450 °C.

D'autres caractéristiques et avantages de l'invention ressortiront mieux à la lecture de la description qui va suivre, donnée à titre illustratif et non limitatif en référence aux figures annexées dans lesquelles :

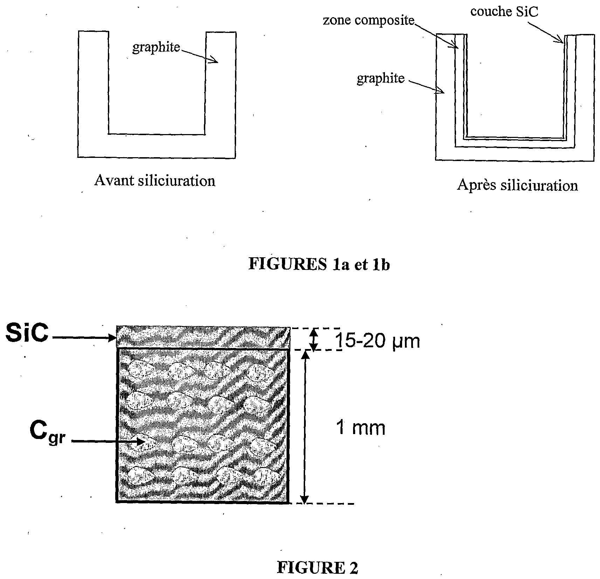

- les figures 1a et 1b sont des représentations schématiques en coupe transversale d'un creuset avant et après traitement selon un procédé conforme à l'invention.
- la figure 2 est une représentation schématique en coupe transversale d'un détail de la partie intérieure d'un creuset conforme à l'invention et sur laquelle sont représentées la couche de surface SiC et la structure de la zone composite formant la couche intermédiaire.

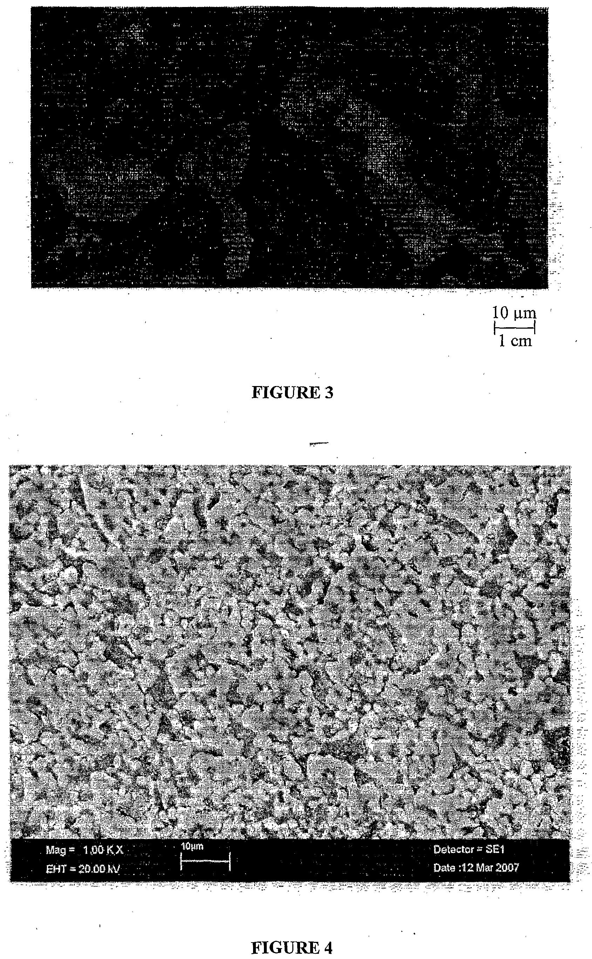

- la figure 3 est une photographie (microscope optique, grossissement * 10³) de la structure composite intermédiaire obtenue au cours de l'étape 3 du procédé selon l'invention, après 2 minutes d'infiltration à 1460 °C de silicium liquide sur un graphite Carbone Lorraine 2020. La matrice graphite est en gris foncé, le carbure de silicium en gris clair et le silicium non réagi apparaît en blanc dans les pores.
- la figure 4 est une photographie au Microscope Electronique à Balayage du matériau obtenu à partir d'un matériau graphite POCO AX2-5Q à l'issue de l'étape 4 d'un procédé selon l'invention. Les nodules de graphite apparaissent en gris foncé, la matrice SiC en gris clair. Il n'y a plus de silicium non réagi visible dans les pores.

Il convient de noter que, pour des raisons de clarté, les différentes couches de matériau des structures visibles sur les figures sont représentées en échelle libre ; les dimensions de certaines parties étant fortement exagérées.

### Description détaillée d'une pièce de matériau conforme à l'invention

Comme précisé précédemment, la pièce de matériau selon l'invention possède au moins une couche support carbonée, une couche dite de surface formée pour l'essentiel de carbure de silicium et une couche dite intermédiaire, intercalée entre les deux couches précédentes et formée d'une zone composite possédant une structure SiC contenant au moins un et de préférence plusieurs nodules de graphite.

La fraction volumique de la structure SiC peut varier de 45 à 70 %. D'une manière générale, la fraction volumique du SiC dans la zone composite est égale à la fraction volumique de la porosité graphite formant la pièce de matériau d'origine, c'est-à-dire avant traitement selon l'invention, multipliée par au moins 1,2 de préférence par au moins 1,5 et plus préférentiellement par 1,8.

L'épaisseur de la couche « de surface » et de la couche « intermédiaire » réunies est avantageusement supérieure à 300 µm, et préférentiellement de 500 à 2000 µm.

En ce qui concerne la couche support, elle est préférentiellement carbonée. Au sens de la présente invention, une couche à base d'un matériau carboné est figurée par un matériau formé, pour l'essentiel, d'atomes de carbone.

Plus précisément, un matériau carboné est, au sens de l'invention, un matériau dont la teneur en atomes de carbone est supérieure à 95 %, en particulier supérieure à 99 % en poids par rapport à son poids total.

Il s'agit de graphite.

Ce matériau carboné possède une porosité ouverte.

La porosité volumique ouverte varie de 25 % à 40 %, préférentiellement de 30 % à 35 %. Cette porosité peut-être caractérisée par la méthode de porosimétrie mercure.

La structure est par ailleurs constituée de grains de graphite de dimensions micrométriques variant de 1 à 10 µm, avantageusement de 1 à 5 µm et de préférence distants de quelques micromètres, en particulier de 1 à 10 µm, avantageusement de 1 à 5 µm.

### Description détaillée du procédé selon l'invention

Avantageusement, la pièce de matériau à traiter selon l'invention possède en surface une couche carbonée possédant une taille de grains compatible avec une siliciuration sur une profondeur millimétrique et avec un taux de réaction suffisant pour que la structure finale soit composée de nodules de graphite dispersés dans une matrice de carbure de silicium.

Sa structure carbonée possède une porosité ouverte conforme à celle définie précédemment.

Il est possible d'utiliser des graphites à porosité volumique ouverte plus faible que 25 %, que l'on soumet à un traitement d'oxydation pour augmenter cette porosité sur une profondeur millimétrique. Dans ce cas, il est nécessaire de partir d'une structure graphite à grains suffisamment fins pour assurer une bonne tenue mécanique à l'issue du traitement. On peut également revêtir un graphite trop dense avec une couche de graphite de porosité souhaitée pour mettre en oeuvre le processus d'infiltration et obtenir la structure désirée de nodules de graphite dans une matrice de carbure de silicium.

En revanche, des graphites à grains grossiers ne s'avèrent pas satisfaisants dans le cadre de la présente invention, du fait de la présence, en fin de traitement de siliciuration, de silicium non réagi dans les pores.

La pièce de matériau mise en oeuvre en étape (2) du procédé selon l'invention est mise en contact avec du silicium liquide, par exemple par immersion dans un bain de silicium fondu.

Son épaisseur est notamment supérieure à 1 mm

Comme déjà précisé précédemment, à l'issue du procédé selon l'invention, un bilan volumique tenant compte du changement de volume associé à la réaction Si + C → SiC montre que la fraction volumique du SiC dans le composite est égale à la fraction volumique de la porosité initiale du graphite multipliée par 1,8.

Le procédé selon l'invention comprend donc au moins les étapes consistant à disposer une pièce de matériau, comprenant au moins en surface une couche carbonée, à mettre ladite pièce en contact avec du silicium liquide, et à la porter à un premier palier de température propice à l'infiltration du silicium fondu dans le graphite jusqu'au bouchage des pores.

Cette température est au moins égale à la température de fusion du silicium. Ce palier peut être réalisé à des températures variant entre la température de fusion du silicium à savoir d'environ 1410 °C jusqu'à environ 1500 °C, avantageusement d'environ 1410 °C à environ 1450 °C.

En fonction de la température choisie, la durée de ce premier palier peut varier entre 10 minutes et une heure, avantageusement entre 20 minutes et 40 minutes.

A l'issue de cette troisième étape, la pièce de matériau dont la surface externe est formée sur une certaine profondeur, supérieure à 300 µm, d'une matrice de graphite contenant des nodules de SiC et du silicium est soumise à un second palier de température.

La température de ce second palier permet d'homogénéiser la microstructure de la couche externe et en particulier d'achever la consommation du silicium infiltré. Ce palier peut être réalisé à des températures variant entre 1500 °C et 1700 °C, avantageusement entre 1500 °C et 1600 °C.

En fonction de la température choisie, la durée de ce second palier peut varier entre une heure et huit heures, avantageusement entre trois heures et six heures. Dans tous les cas, cette durée est suffisante pour permettre la poursuite de la transformation du graphite en une structure carbure de silicium incorporant des nodules de graphite et l'élimination sensiblement totale du silicium résiduel.

Les troisième et quatrième étapes du procédé peuvent être réalisées à pression variable, généralement à pression atmosphérique ou pression inférieure. Il est toutefois constaté qu'une réalisation sous vide permet avantageusement par pré-siliciurisation en phase gazeuse des grains de graphite, une meilleure pénétration du silicium liquide lors de la deuxième étape. L'infiltration peut alors se réaliser sur une épaisseur de 15 % à 20 % plus importante que l'épaisseur obtenue à pression atmosphérique.

Ces étapes sont généralement réalisées sous atmosphère inerte ou sous vide.

L'invention va maintenant être décrite au moyen de l'exemple suivant donné bien entendu à titre illustratif et non limitatif de l'invention.

### Exemple 1

La nuance testée est une plaque du matériau graphique POCO AXZ-5Q (longueur 10 cm, largeur 10 cm, épaisseur 1cm), de porosité volumique 32 % et de taille de grains de l'ordre de 1 µm.

Le matériau est chauffé sous atmosphère de gaz neutre (Argon) dans un four à induction. La température d'infiltration choisie est T = 1430 °C, légèrement supérieure à la température de fusion du silicium.

Après un palier de 30 minutes à T = 1430 °C, le matériau est soumis à une température de 1500 °C pendant 6 heures pour homogénéiser la microstructure de la couche externe de 15-20 microns et achever la consommation du silicium infiltré.

L'ensemble est refroidi à température ambiante à la vitesse de 5 °C/mn jusqu'à 900 °C puis par refroidissement naturel après arrêt du chauffage.

## Revendications

1. Pièce de matériau, notamment dédiée à une mise en contact avec du silicium liquide, possédant une architecture multicouche formée d'au moins une couche dite « de support » à base de carbone constituée de grains de graphite de dimension micrométrique, variant de 1 à 10 µm et possédant une porosité ouverte variant de 25 % à 40 %, d'une couche dite « de surface » en carbure de silicium et d'une couche dite « intermédiaire » intercalée entre lesdites couches de support et de surface, **caractérisée en ce que** ladite couche intermédiaire est formée d'une matrice de carbure de silicium contenant au moins 30 % en volume de nodule(s) de carbone avec la fraction volumique du carbure de silicium formant ladite couche intermédiaire variant de 45 % à 70 % et étant égale à la fraction volumique de la porosité initiale du graphite formant la couche de support à base de carbone, multipliée par au moins 1,2.

2. Pièce de matériau selon la revendication 1, dans laquelle les couches de surface et intermédiaire possèdent moins de 5 %, notamment moins de 1 % en volume de silicium solide et en particulier sont totalement dénuées de silicium solide.

3. Pièce de matériau selon la revendication 1 ou 2, dans laquelle la matrice de carbure de silicium formant la couche intermédiaire comprend au moins 40 % en volume de nodule(s) de carbone.

4. Pièce de matériau selon l'une quelconque des revendications précédentes possédant une couche intermédiaire d'épaisseur d'au moins 300 µm, en particulier supérieure à 400 µm et notamment variant de 500 µm à 2000 µm.

5. Procédé utile pour la préparation d'une pièce de matériau possédant une architecture multicouche composée d'au moins une couche dite « de support » à base de carbone constituée de grains de graphite de dimension micrométrique, variant de 1 à 10 µm et possédant une porosité ouverte variant de 25 % à 40 %, d'une couche dite « de surface » en carbure de silicium et d'une couche dite « intermédiaire » intercalée entre les deux précédentes couches, formée d'au moins une matrice de carbure de silicium contenant au moins 30 % en volume de nodule(s) de carbone avec la fraction volumique du carbure de silicium formant ladite couche intermédiaire variant de 45 % à 70 % et étant égale à la fraction volumique de la porosité du graphite de la couche de support à base de carbone, multipliée par 1,8, ledit procédé comprenant au moins les étapes consistant à :
(1) disposer d'une pièce de matériau comprenant au moins une couche externe carbonée de porosité volumique variant de 25 à 40 %, de préférence de 30 à 35 % et s'étendant de préférence sur une épaisseur d'au moins 1000 µm,
(2) mettre en contact ladite pièce avec du silicium liquide,
(3) maintenir l'ensemble à une température variant de 1410 à 1500 °C et propice à l'infiltration dudit silicium liquide dans les pores de la couche carbonée, et la formation d'une zone composite formée d'une matrice de graphite intégrant des nodules de SiC, et
(4) porter la pièce obtenue à l'issue de l'étape précédente à une température comprise entre 1500 °C et 1700 °C et de préférence de 1500 à 1600 °C pour former lesdites couches de surface et intermédiaire attendues et consommer pour l'essentiel le silicium résiduel de l'étape précédente.

6. Procédé selon la revendication 5, dans lequel l'épaisseur de la couche de surface et la couche intermédiaire réunies est supérieure à 300 µm, préférentiellement de 500 à 2000 µm.

7. Procédé selon l'une quelconque des revendications 5 à 6, dans lequel la couche carbonée est constituée de grains de graphite de dimension micrométrique, variant de 1 à 5 µm.

8. Procédé selon l'une quelconque des revendications 5 à 7, dans lequel l'étape (3) est réalisée à une température variant de 1410 à 1450 °C.

9. Procédé selon l'une quelconque des revendications 5 à 8, dans lequel ladite pièce est maintenue au palier de température de l'étape (3) pendant 10 minutes à 1 heure, préférentiellement de 20 minutes à 40 minutes.

10. Procédé selon l'une quelconque des revendications 5 à 9 dans lequel l'étape (4) est réalisée à une température variant de 1500 °C à 1700 °C, avantageusement de 1500 °C à 1600 °C.

11. Procédé selon l'une quelconque des revendications 5 à 10 dans lequel ladite pièce est maintenue au palier de l'étape (4) pendant 1 h à 8 heures, préférentiellement de 3 à 6 heures.

## Patentansprüche

1. Materialteil, insbesondere dazu bestimmt, mit flüssigem Silizium in Kontakt gebracht zu werden, das einen mehrschichtigen Aufbau aufweist und gebildet wird durch mindestens eine als "Tragschicht" bezeichnete Schicht auf der Basis von Kohlenstoff, die gebildet wird durch Körner aus Graphit mit mikrometrischen Abmessungen, die zwischen 1 und 10 µm variieren, und die eine offene Porosität aufweisen, die zwischen 25% und 40% variiert, eine als "Oberflächenschicht" bezeichnete Schicht aus Siliziumkarbid, und eine als "Zwischenschicht" bezeichnete Schicht, die zwischen der Tragschicht und der Oberflächenschicht eingefügt ist, **dadurch gekennzeichnet, dass** die genannte Zwischenschicht gebildet ist aus einer Matrix von Siliziumkarbid, die mindestens 30 Vol.% Knötchen aus Kohlenstoff enthält, wobei der Volumenanteil des Siliziumkarbids, das die genannte Zwischenschicht bildet, zwischen 45% und 70% variiert und gleich dem mit mindestens 1,2 multiplizierten Volumenanteil der anfänglichen Porosität des Graphits ist, der die Tragschicht auf der Basis von Kohlenstoff bildet.

2. Materialteil nach Anspruch 1, bei dem die Oberflächenschicht und die Zwischenschicht weniger als 5%, insbesondere weniger als 1 Vol.% festes Silizium erhalten und insbesondere vollständig von festem Silizium frei sind.

3. Materialteil nach Anspruch 1 oder 2, bei dem die Matrix aus Siliziumkarbid, die die Zwischenschicht bildet, wenigstens 40 Vol.% Knötchen aus Kohlenstoff enthält.

4. Materialteil nach einem der vorstehenden Ansprüche, mit einer Zwischenschicht mit einer Dicke von wenigstens 300 µm, insbesondere mehr als 400 µm und insbesondere zwischen 500 µm und 2000 µm.

5. Verfahren für die Herstellung eines Materialteils, das insbesondere dazu bestimmt ist, mit flüssigem Silizium in Kontakt gebracht zu werden, und das einen mehrschichtigen Aufbau aufweist und gebildet wird durch mindestens eine als "Tragschicht" bezeichnete Schicht auf der Basis von Kohlenstoff, die gebildet wird durch Körner aus Graphit mit mikrometrischen Abmessungen, die zwischen 1 und 10 µm variieren, und die eine offene Porosität aufweisen, die zwischen 25% und 40% variiert, eine als "Oberflächenschicht" bezeichnete Schicht aus Siliziumkarbid, und eine als "Zwischenschicht" bezeichnete Schicht, die zwischen der Tragschicht und der Oberflächenschicht eingefügt ist und die gebildet ist aus einer Matrix von Siliziumkarbid, die mindestens 30 Vol.% Knötchen aus Kohlenstoff enthält, wobei der Volumenanteil des Siliziumkarbids, das die genannte Zwischenschicht bildet, zwischen 45% und 70% variiert und gleich dem mit mindestens 1,8 multiplizierten Volumenanteil der anfänglichen Porosität des Graphits ist, der die Tragschicht auf der Basis von Kohlenstoff bildet, welches Verfahren wenigstens die folgenden Schritte umfasst:
(1) Bereitstellen eines Materialteils, das wenigstens eine karbonisierte äußere Schicht aufweist, mit einer Volumenporosität zwischen 25 und 40%, vorzugsweise 30 bis 35%, die sich vorzugsweise über eine Dicke von wenigstens 1000 µm erstreckt,
(2) in Kontakt bringen des genannten Teils mit flüssigem Silizium,
(3) Halten des Gebildes auf einer Temperatur zwischen 1410 und 1500 C°, die günstig ist für die Infiltration der karbonisierten Schicht mit dem flüssigen Silizium und die Bildung einer Kompositzone, die durch eine Matrix aus Graphit gebildet wird, die Knötchen aus SiC enthält, und
(4) Bringen des am Ende des vorstehenden Schrittes erhaltenen Teils auf eine Temperatur zwischen 1500 C° und 1700C°, vorzugsweise von 1500 bis 1600C°, um die erwarteten Oberflächen- und Zwischenschichten zu bilden und den Hauptteil des restlichen Siliziums aus dem vorangehenden Schritt zu verbrauchen.

6. Verfahren nach Anspruch 5, bei dem die gemeinsame Dicke der Oberflächenschicht und der Zwischenschicht größer als 300 µm ist, vorzugsweise zwischen 500 und 2000 µm beträgt.

7. Verfahren nach einem der Ansprüche 5 bis 6, bei dem die karbonisierte Schicht durch Körner aus Graphit gebildet wird, die mikrometrische Abmessungen haben, die zwischen 1 und 5 µm variieren.

8. Verfahren nach einem der Ansprüche 5 bis 7, bei dem der Schritt (3) bei einer Temperatur zwischen 1410 und 1450 C° ausgeführt wird.

9. Verfahren nach einem der Ansprüche 5 bis 8, bei dem das genannte Teil in Schritt (3) für eine Dauer von 10 Minuten bis 1 Stunde, vorzugsweise von 20 Minuten bis 40 Minuten in dem Temperaturzustand gehalten wird.

10. Verfahren nach einem der Ansprüche 5 bis 9, bei dem der Schritt (4) bei einer Temperatur zwischen 1500 C° und 1700C°, bevorzugt zwischen 1500C° und 1600C° ausgeführt wird.

11. Verfahren nach einem der Ansprüche 5 bis 10, bei dem das genannte Teil in für eine Dauer von 1 bis 8 Stunden, vorzugsweise von 3 bis 6 Stunden, in dem Zustand in Schritt (4) gehalten wird.

## Claims

1. A material part, notably intended to be put into contact with liquid silicon, possessing a multilayer architecture formed of at least one layer called the "support layer" based on carbon consisting of graphite grains of micrometric size varying from 1 to 10 µm and having an open volume porosity varying from 25% to 40%, a layer called the "surface layer" made of silicon carbide, and a layer called the "intermediate layer" inserted between said support and surface layers, **characterized in that** said intermediate layer is formed of a matrix of silicon carbide containing at least 30% by volume of a carbon nodule or nodules, with the volume fraction of silicon carbide forming said intermediate layer varying from 45% to 70% and being equal to the volume fraction of the initial porosity of the graphite forming the support layer based on carbon, multiplied by at least 1.2.

2. The material part as claimed in claim 1, wherein the surface and intermediate layers possess less than 5%, notably less than 1% by volume of solid silicon and in particular are totally devoid of solid silicon.

3. The material part as claimed in claim 1 or 2, wherein the silicon carbide matrix forming the intermediate layer contains at least 40% by volume of a carbon nodule or nodules.

4. The material part as claimed in any one of the preceding claims, possessing an intermediate layer with a thickness of at least 300 µm, in particular greater than 400 µm, and notably varying from 500 µm to 2000 µm.

5. A method useful for preparing a material part possessing a multilayer architecture composed of at least one layer called the "support layer" based on carbon consisting of graphite grains of micrometric size varying from 1 to 10 µm and having an open volume porosity varying from 25% to 40%, a layer called the "surface layer" made of silicon carbide and a layer called the "intermediate layer" inserted between the two preceding layers, formed of at least one silicon carbide matrix containing at least 30% by volume of a carbon nodule or nodules, with the volume fraction of silicon carbide forming said intermediate layer varying from 45% to 70% and being equal to the volume fraction of the graphite porosity of the carbon-based support layer multiplied by 1.8, said method comprising at least the steps consisting of:
(1) making use of a material part comprising at least one external carbonaceous layer with a volume porosity varying from 25% to 40%, preferably from 30% to 35%, and preferably extending over a thickness of at least 1000 µm,
(2) putting said part into contact with liquid silicon,
(3) holding the assembly at a temperature varying from 1410 to 1500°C and favorable to the infiltration of said liquid silicon into the pores of the carbonaceous layer and to the formation of a composite zone formed of a graphite matrix incorporating SiC nodules, and
(4) bringing the part obtained at the end of the preceding step to a temperature between 1500°C and 1700°C, preferably from 1500°C to 1600°C, in order to form said anticipated surface and intermediate layers and to consume the essential part of residual silicon from the preceding step.

6. The method as claimed in claim 5, wherein the thickness of the surface layer and the intermediate layer together is greater than 300 µm, preferably from 500 to 2000 µm.

7. The method as claimed in any one of claims 5 to 6, wherein the carbonaceous layer consists of graphite grains of micrometric size varying from 1 to 5 µm.

8. The method as claimed in any one of claims 5 to 7, wherein step (3) is carried out at a temperature varying from 1410 to 1450°C.

9. The method as claimed in any one of claims 5 to 8, wherein said part is kept at the temperature level of step (3) for 10 minutes to 1 hour, preferably from 20 minutes to 40 minutes.

10. The method as claimed in any one of claims 5 to 9, wherein step (4) is carried out at a temperature varying from 1500°C to 1700°C, advantageously from 1500°C to 1600°C.

11. The method as claimed in any one of claims 5 to 10, wherein said part is kept at the level of step (4) for 1 to 8 hours, preferably for 3 to 6 hours.
